# EUROPEAN PATENT SPECIFICATION

(11) **EP 3 182 451 B1**
(45) Date of publication and mention of the grant of the patent: **19.09.2018**
(21) Application number: 16203788.1
(22) Date of filing: 13.12.2016
(51) Int. Cl.: H01L 25/075, H01L 33/38, H01L 33/50

(54) **LIGHT-EMITTING DIODE ARRAY AND LIGHTING DEVICE FOR VEHICLES**
LEUCHTDIODENARRAY UND BELEUCHTUNGSVORRICHTUNG FÜR FAHRZEUGE
RÉSEAU DE DIODES ÉLECTROLUMINESCENTES ET DISPOSITIF D'ÉCLAIRAGE POUR VÉHICULES

(30) Priority: 15.12.2015 JP 2015243987
(43) Date of publication of application: 21.06.2017
(73) Proprietor: Stanley Electric Co., Ltd., Meguro-ku Tokyo 153 (JP)
(72) Inventor: MIYACHI, Mamoru, Tokyo, 153-8636 (JP); TANAKA, Satoshi, Tokyo, 153-8636 (JP)
(74) Representative: Klang, Alexander H.

(56) References cited:
- EP-A2- 2 357 679
- EP-A2- 2 405 491
- US-A1- 2003 230 754
- US-A1- 2015 292 682

## Description

### FIELD OF THE INVENTION

The present invention relates to a light-emitting diode array including a plurality of light-emitting diodes (in the following also named "semiconductor light-emitting elements"), and a lighting device for vehicles.

### BACKGROUND

Semiconductor light-emitting elements including a nitride semiconductor such as GaN can emit ultraviolet light to blue light and further emit white light by using a phosphor (For example, US 2013/0277696 A1, the patent family member of Japanese Laid-open Patent Publication No. 2012-138499). Such semiconductor light-emitting elements are applied to, for example, lighting apparatuses such as lighting devices for vehicles. In the case where semiconductor light-emitting elements are used in, for example, a headlight (headlamp) for vehicles, for which a high optical output is required, in general, a semiconductor light-emitting element array including a plurality of semiconductor light-emitting elements is used.

### SUMMARY

A main object of the present invention is to provide a semiconductor light-emitting element array in which uneven color (chromaticity distribution) can be suppressed.

According to another aspect of this invention, there is provided a semiconductor light-emitting element array (100) comprising a substrate (12) and a plurality of semiconductor light-emitting elements (90) arranged above the substrate in one direction, wherein each of the semiconductor light-emitting elements includes: an optical semiconductor laminate (20) in which a p-type semiconductor layer (24), an active layer (23) having a light-emitting property, and an n-type semiconductor layer (22) are sequentially laminated from the substrate side; a via hole (20d) that penetrates the p-type semiconductor layer and the active layer from the substrate side; an n-side electrode (50) that is in contact with the n-type semiconductor layer through the via hole; and a p-side electrode (30) disposed on a surface of the p-type semiconductor layer so as to avoid the via hole, wherein, in case that a ratio of a total area of the via hole to an area of the optical semiconductor laminate is defined as a via area ratio, and that a semiconductor light-emitting element having the highest via area ratio among the semiconductor light-emitting elements is defined as a maximum-via-area-ratio element, via area ratios of semiconductor light-emitting elements except for the maximum-via-area-ratio element tend to decrease monotonically with increasing distance from the maximum-via-area-ratio element.

### BRIEF DESCRIPTION OF THE DRAWINGS

Figs. 1A to 1I are sectional views that illustrate some steps of a method for producing a semiconductor light-emitting element array;
Fig. 1J a plan view illustrating a part of the semiconductor light-emitting element array;
Figs. 2A to 2D include plan views illustrating overall structures of first to third semiconductor light-emitting element arrays, which are mainly examined by the inventors of the present invention;
Fig. 3 is a schematic diagram illustrating a driving example of a semiconductor light-emitting element array; and
Fig. 4 is a schematic view illustrating a lighting device for vehicles, the lighting device including a semiconductor light-emitting element array.

### DESCRIPTION OF THE PREFERRED EMBODIMENTS

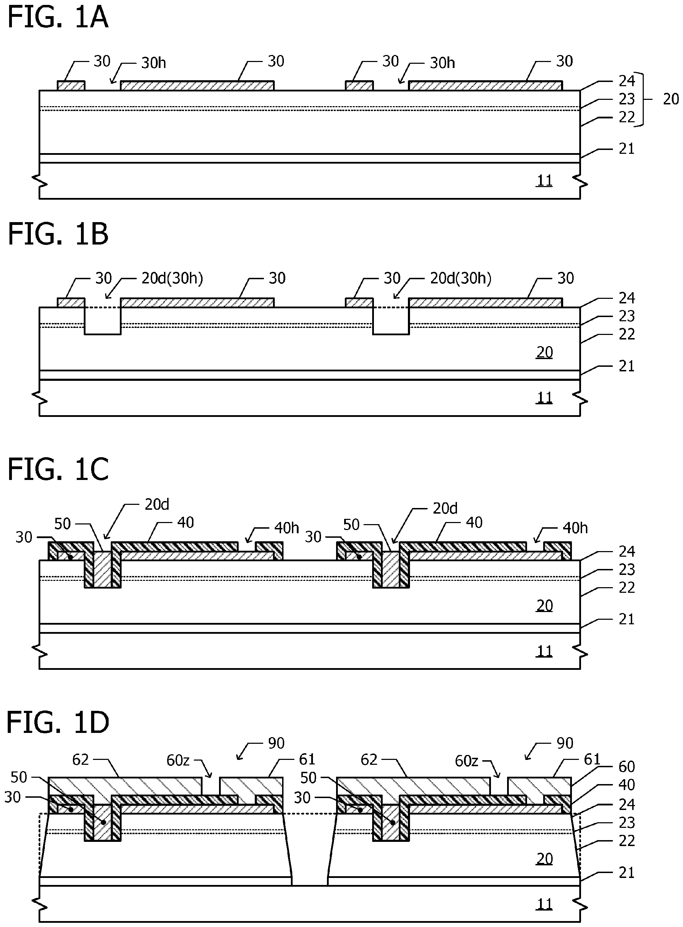

A method for producing a semiconductor light-emitting element array (LED array) and a basic structure, the method and the basic structure being examined by the inventors of the present invention, will now be described with reference to Figs. 1A to 1J. An LED array described below is used in, for example, a headlight (headlamp) for vehicles.

Figs. 1A to II are sectional views that illustrate some steps of a method for producing an LED array. Note that the relative sizes, the positional relationships, and the like of components illustrated in the drawings are different from those of actual components.

As illustrated in Fig. 1A, an optical semiconductor laminate 20 including GaN-based semiconductors is formed above a growth substrate 11 by metal organic chemical vapor deposition (MOCVD). For example, a sapphire substrate is used as the growth substrate 11. Alternatively, a substrate formed of, for example, spinel or ZnO may be used as the growth substrate 11.

First, the growth substrate 11 is subjected to thermal cleaning, and a buffer layer 21 formed of GaN is then grown on the growth substrate 11. Subsequently, an n-type semiconductor layer 22 formed of n-type GaN doped with Si or the like, an active layer (light-emitting layer) 23 having a multiple quantum well structure including well layers (InGaN) and barrier layers (GaN), and a p-type semiconductor layer 24 formed of p-type GaN doped with Mg or the like are sequentially grown to form an optical semiconductor laminate 20.

Subsequently, a p-side electrode 30 is formed on a surface of the optical semiconductor laminate 20 (surface of the p-type semiconductor layer 24). Specifically, a multilayer film formed of, for example, indium tin oxide (ITO)/Ag/Ti/Pt/Au is deposited by electron beam evaporation, sputtering, or the like. Subsequently, the multilayer film is patterned by, for example, a photolithographic method or a lift-off method to form the p-side electrode 30 having a particular shape. The p-side electrode 30 is patterned so as to have openings 30h.

Next, as illustrated in Fig. 1B, regions of the optical semiconductor laminate 20, the regions corresponding to the openings 30h of the p-side electrode 30, are etched by a dry etching method (with chlorine gas) using a resist mask to form vias 20d. The vias 20d penetrate the p-type semiconductor layer 24 and the active layer 23, and the n-type semiconductor layer 22 is exposed on the bottom surfaces of the vias 20d.

At least one via 20d is formed in the optical semiconductor laminate 20. The planar shape, the arrangement position, and the like of the least one via 20d will be described below.

Next, as illustrated in Fig. 1C, an n-side electrode 50 that is in contact with the n-type semiconductor layer 22 is formed in the vias 20d of the optical semiconductor laminate 20.

Specifically, a SiO₂ film is deposited on the p-side electrode 30 and in the vias 20d of the optical semiconductor laminate 20 by, for example, sputtering. Alternatively, another insulating material such as SiON may be used instead of SiO₂.

Subsequently, the SiO₂ film located on a part of the upper surface of the p-side electrode 30 and on bottom surface portions of the vias 20d is etched by a dry etching method (with CF₄/Ar mixed gas) using a resist mask to form an insulating layer 40.

The n-type semiconductor layer 22 is exposed on bottom surfaces of the vias 20d. Contact holes 40h are formed in the insulating layer 40, and a part of the p-side electrode 30 is also exposed in the contact holes 40h.

Subsequently, a metal multilayer film formed of, for example, Ti/Ag/Ti/Pt/Au is deposited by electron beam evaporation, sputtering, or the like mainly in regions where the n-type semiconductor layer 22 in the vias 20d is exposed. The metal multilayer film is then patterned by a lift-off method or the like to form the n-side electrode 50.

Next, as illustrated in Fig. 1D, a first joining layer 60 is formed on the insulating layer 40 and the n-side electrode 50. First, a metal multilayer film formed of, for example, Ti/Pt/Au is deposited on the insulating layer 40 and the n-side electrode 50 by electron beam evaporation, sputtering, or the like. Subsequently, the metal multilayer film is patterned by a lift-off method or the like to form the first joining layer 60 having gaps 60z.

The first joining layer 60 is divided into first conductive regions 61 and second conductive regions 62 by the gaps 60z. Each of the first conductive regions 61 is connected to the p-side electrode 30, and each of the second conductive regions 62 is connected to the n-side electrode 50.

Subsequently, a part of the optical semiconductor laminate 20 is etched by a dry etching method (with chlorine gas) using a resist mask to divide the optical semiconductor laminate 20 into pieces each having a desired size. A layered structure including the optical semiconductor laminate 20 to the first joining layer 60 on the growth substrate 11 is regarded as a semiconductor light-emitting diode (LED). This layered structure is referred to as an LED structural layer 90. Note that in the illustration of the subsequent drawings, LED structural layers 90 are vertically flipped.

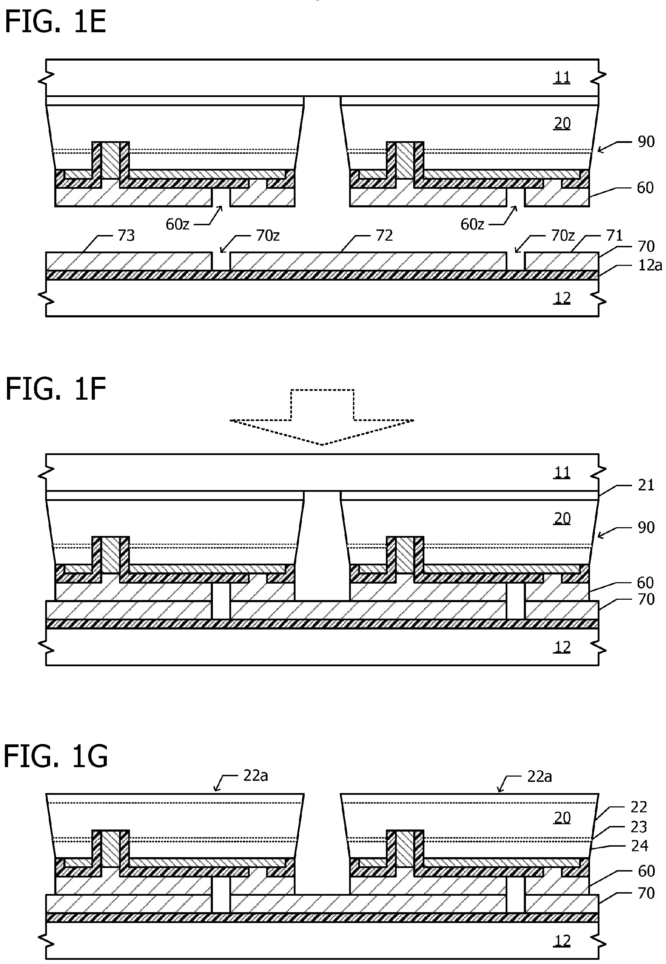

Next, the LED structural layers 90 are fixed to a support substrate 12, and the growth substrate 11 is then detached from the LED structural layers 90. First, a support substrate 12 for fixing the LED structural layers 90 is prepared (refer to Fig. 1E).

For example, a Si substrate is used as the support substrate 12. Alternatively, for example, sapphire, GaN, Ge, Mo, CuW, or AlN may be used instead of Si.

A second joining layer 70 having a pattern is formed on the support substrate 12 with an insulating film 12a formed of, for example, SiO₂ therebetween. The second joining layer 70 is a metal multilayer film formed of, for example, Ti/Ni/Au/Pt/AuSn and includes a plurality of conductive regions (for example, a first conductive region 71 to a third conductive region 73) arranged with gaps 70z therebetween.

Next, as illustrated in Fig. 1E, the LED structural layers 90 are arranged so as to face the support substrate 12. Specifically, the LED structural layers 90 and the support substrate 12 are arranged such that the gaps 60z of the first joining layer 60 face the corresponding gaps 70z of the second joining layer 70.

Next, as illustrated in Fig. 1F, the first joining layer 60 and the second joining layer 70 are brought into contact with each other and held for two minutes while heating at 200°C under a pressure of 3 MPa. Subsequently, cooling is performed to room temperature to fusion-bond the first joining layer 60 and the second joining layer 70 to each other. As a result, the LED structural layers 90 are fixed on the support substrate 12.

Subsequently, the growth substrate 11 is separated from the optical semiconductor laminate 20 by a laser lift-off method. Specifically, a KrF excimer laser beam is applied from the growth substrate side to thermally decompose a part of the buffer layer 21. As a result, the LED structural layers 90 (optical semiconductor laminate 20) and the growth substrate 11 are separated from each other.

Next, as illustrated in Fig. 1G, a so-called micro-cone structure layer (fine irregularity layer) 22a is formed on the exposed surface of the n-type semiconductor layer 22. Specifically, the surface of the n-type semiconductor layer 22 is wet-etched by using, for example, an aqueous solution of phenyltrimethylammonium hydroxide (TMAH) (temperature: about 70°C, concentration: about 25%). By forming the micro-cone structure layer 22a, light radiated from the optical semiconductor laminate 20 can be efficiently emitted to the outside.

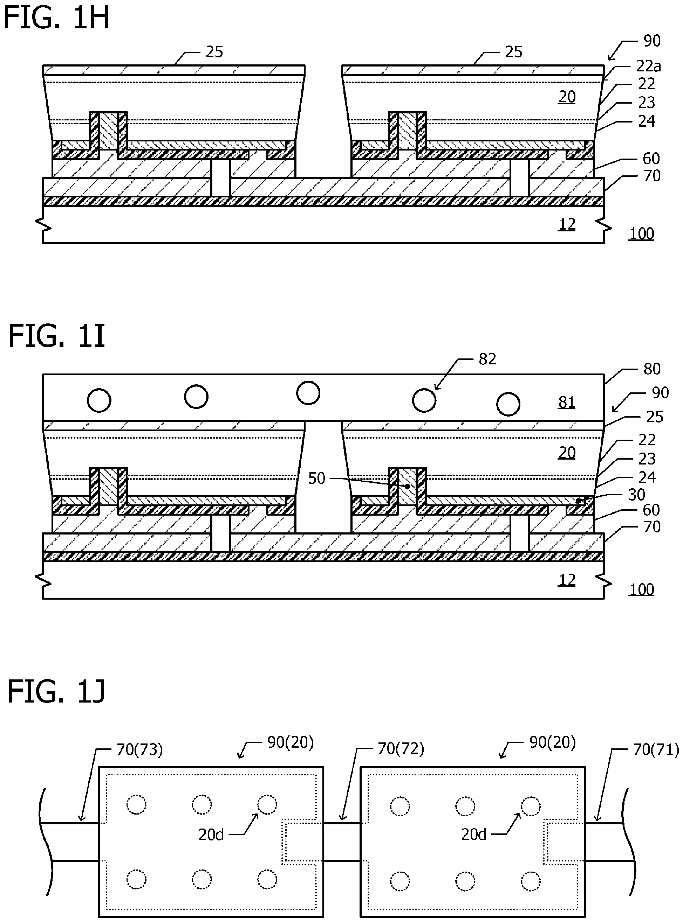

Next, as illustrated in Fig. 1H, a surface protective film 25 formed of, for example, SiO₂ is formed on the n-type semiconductor layer 22 (micro-cone structure layer 22a) by chemical vapor deposition (CVD) or the like. The support substrate 12 is then divided by laser scribing or dicing so as to have a particular size including a plurality of LED structural layers 90 (for example, a size including six LED structural layers 90).

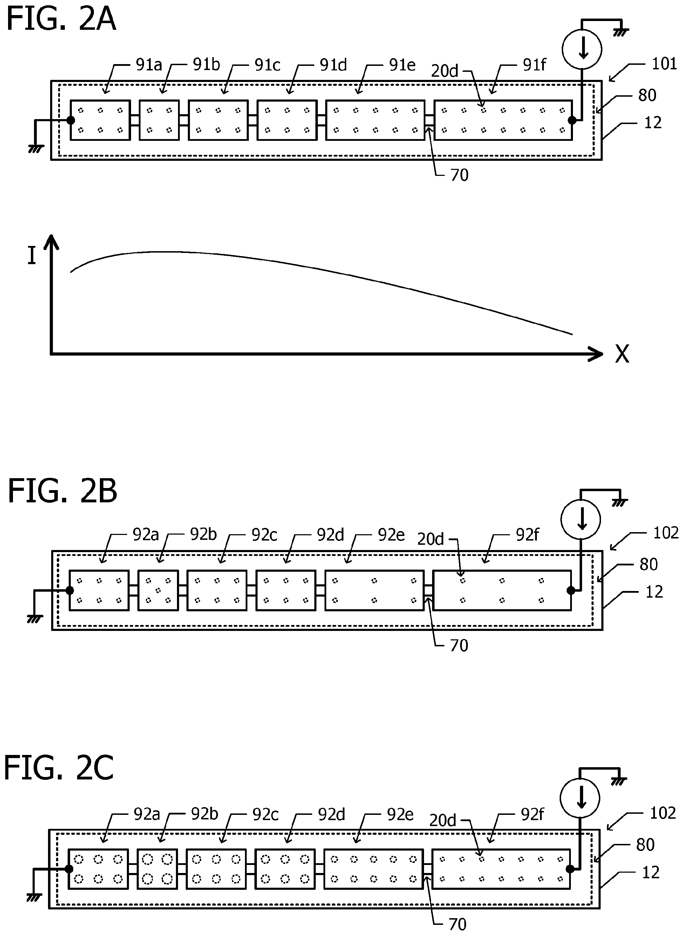

Through the above steps, an LED array 100 including a plurality of LED structural layers 90 is produced. As described below (refer to Figs. 2A to 2C), an LED array includes, for example, six LED structural layers arranged in one direction. Note that white light can be obtained by further providing a wavelength conversion layer (phosphor layer) on the LED array.

As illustrated in Fig. 1I, a wavelength conversion layer 80 is formed on the divided support substrate 12 so as to cover the plurality of LED structural layers 90. The wavelength conversion layer 80 can be formed by dropping or applying a paste-like matrix material 81 containing a phosphor material 82 onto the LED structural layers 90, and then curing the matrix material 81.

The matrix material 81 may be a light-transmissive thermosetting resin such as a silicone resin or an epoxy resin. An example of the phosphor material 82 is yttrium aluminum garnet (YAG).

The concentration of the phosphor material 82 in the matrix material 81 is about 50% by weight. The wavelength conversion layer 80 has a thickness of about 50 µm.

Thus, an LED array 100 with the wavelength conversion layer 80 is produced. Hereinafter, for the sake of convenience, an LED array including a wavelength conversion layer may also be referred to as an LED array.

The plurality of LED structural layers 90 are electrically connected in series through a second conductive layer 70. When a hole and an electron are injected (that is, a current is supplied) into the optical semiconductor laminate 20 through the second conductive layer 70 (or the p-side electrode 30 and the n-side electrode 50 connected to the second conductive layer 70), the hole and the electron are recombined in the active layer 23, and energy corresponding to the recombination is released in the form of light (and heat).

The light released from the active layer 23 is mainly emitted from the surface of the n-type semiconductor layer 22 (surface of the surface protective film 25). Part of the emitted light passes through the wavelength conversion layer 80 and is emitted from the wavelength conversion layer 80. The other part of light is converted by the phosphor material 82 to light having a different wavelength and emitted from the wavelength conversion layer 80.

When GaN-based semiconductors are used in the optical semiconductor laminate, blue light is emitted from the optical semiconductor laminate. When YAG is used as the phosphor material, yellow light is emitted form the phosphor material (or the wavelength conversion layer). An LED array that emits white light is obtained by combining the optical semiconductor laminate containing GaN-based semiconductors and the wavelength conversion layer containing YAG.

Fig. 1J is a plan view illustrating a part of an LED array. LED structural layers 90 are arranged on a support substrate 12 in one direction and electrically connected in series through a (second) conductive layer 70. In the drawing, parts of the conductive layer 70, the parts being hidden below the LED structural layers 90, are indicated by a broken line.

A plurality of vias 20d are formed in the optical semiconductor laminate 20 (refer to Fig. 1B). The planar shape of each of the vias 20d is, for example, a circular shape. In the optical semiconductor laminate 20, the active layer (and the p-type semiconductor layer) have been removed from the regions where the vias 20d are formed. Therefore, these regions are regions from which light is not emitted (non-light-emitting regions). In the drawing, the vias 20d are indicated by a broken line.

Herein, a ratio of a total area of vias provided in an LED structural layer (or an optical semiconductor laminate thereof) to an area of the LED structural layer is defined as a via area ratio. Herein, the area of each of the vias is assumed to be equal to the area of the opening formed in the p-type semiconductor layer. The inventors of the present invention prepared a plurality of LED arrays having different via area ratios. Examinations and evaluations of the LED arrays were performed.

The upper part of Fig. 2A is a plan view illustrating an overall structure of a first LED array 101 (reference example). Note that in the drawing, a wavelength conversion layer 80 and vias 20d are indicated by a broken line.

The LED array 101 includes, for example, six LED structural layers arranged in one direction and a wavelength conversion layer 80 disposed so as to cover the LED structural layers. The six LED structural layers are referred to as a first LED structural layer 91a to a sixth LED structural layer 91f in order from the left side in the drawing.

The six LED structural layers 91a to 91f are electrically connected in series and connected to, for example, a direct-current power supply device. Each of the LED structural layers may be driven by an alternating-current (duty) driving system.

The areas of the first to sixth LED structural layers 91a to 91f that form the LED array 101 are different from each other. For example, the second LED structural layer 91b has the smallest area of about 0.10 mm². The first LED structural layer 91a, the third LED structural layer 91c, and the fourth LED structural layer 91d each have an area of about 0.13 mm². The fifth LED structural layer 91e has an area of about 0.21 mm². The sixth LED structural layer 91f has the largest area of about 0.37 mm². In the LED array 101 having this structure, vias 20d having the same size are arranged in each of the LED structural layers in a matrix at predetermined intervals. All the LED structural layers have a via area ratio of about 3.0%.

When a constant current is allowed to flow through the first to sixth LED structural layers 91a to 91f connected in series, the LED structural layers differ in current density and light emission intensity due to the difference in area of the LED structural layers. In this case, there is a negative correlation between the area of the LED structural layer and the light emission intensity thereof.

The lower part of Fig. 2A is a graph showing a light intensity distribution (brightness distribution) of the LED array 101. The horizontal axis of the graph represents a position X in a direction in which the LED array 101 extends (in a direction in which the LED structural layers are arranged). The vertical axis of the graph represents an intensity I of light emitted from the LED array 101.

The LED array 101 has a mountain-shaped or bow-shaped brightness distribution characteristic, as shown in the graph. That is, the LED array 101 has a characteristic that the brightness gradually increases from one end side (for example, the first LED structural layer 91a side) of the LED array 101 toward the other end side (for example, the sixth LED structural layer 91f side), becomes maximum at a certain position, and gradually decreases.

More specifically, the LED array 101 has a characteristic that the brightness becomes maximum at the position of the second LED structural layer 91b and gradually decreases toward the outside (both end sides). From the viewpoint of the areas of the LED structural layers, the area of the second LED structural layer 91b is the smallest, and the area tends to increase monotonically toward the outside (both end sides). In the case where an LED array is used in a headlight for vehicles, the LED array preferably has such a brightness distribution characteristic.

On the other hand, in the case where an LED array is used in a headlight for vehicles, it is desirable that uneven color of the LED array be suppressed (the chromaticity distribution be flattened and made uniform), that is, the LED array appear uniformly white. The inventors of the present invention evaluated the uneven color (chromaticity distribution) when light is emitted from the LED array 101 by supplying a current of about 100 mA to the LED array 101.

The results showed that in the LED array 101, the wavelength of the emitted light was shifted to the short-wavelength side (blue side) at a position where the brightness in the surface is relatively high, and the wavelength of the emitted light was shifted to the long-wavelength side (yellow side) at a position where the brightness in the surface is relatively low. Specifically, the results showed the following. At a position where the brightness is relatively high, light released from the optical semiconductor laminate is further enhanced, and the emitted light appears bluish white. At a position where the brightness is relatively low, light subjected to wavelength conversion in the wavelength conversion layer is further enhanced, and the emitted light appears yellowish white. Specifically, at the position where the second LED structural layer 91b having the highest brightness is disposed, the chromaticity Cx (an x-component in the x-y chromaticity diagram) is about 0.30. At the position where the sixth LED structural layer 91f having the lowest brightness is disposed, the chromaticity Cx is about 0.31.

According to the examinations conducted by the inventors of the present invention, a chromaticity distribution characteristic of an LED array can be adjusted by changing the via area ratios of LED structural layers. More specifically, when the via area ratio is increased, the wavelength of light emitted from the position at which the LED structural layer is disposed can be relatively shifted to the long-wavelength side. On the other hand, when the via area ratio is decreased, the wavelength of light emitted from the position at which the LED structural layer is disposed can be relatively shifted to the short-wavelength side. The reason for this is as follows. A portion where a via is located is a non-light-emitting region, and the color of a phosphor appears strongly at the position right on the via. This color also affects the light-emission color of the entire surface. For example, in the LED array 101, when the via area ratio of the second LED structural layer 91b is increased from 3.0% to 3.7%, the chromaticity Cx at a position where the second LED structural layer 91b is disposed is changed from 0.30 to 0.31.

Fig. 2B is a plan view illustrating an overall structure of a second LED array 102 (first embodiment). The second LED array 102 has the same structure as the first LED array 101 except for the via area ratios of LED structural layers. The six LED structural layers are referred to as a first LED structural layer 92a to a sixth LED structural layer 92f in order from the left side in the drawing. The via area ratios of the LED structural layers may be adjusted by changing the number of vias per unit area (the density of vias) or changing the size (diameter) of each via.

In the LED array 102, the via area ratios of the first LED structural layer 92a to the sixth LED structural layer 92f are different from each other. Specifically, there is a negative correlation between the area of the LED structural layer and the via area ratio thereof. In other words, there is a positive correlation between the light emission intensity of the LED structural layer and the via area ratio thereof.

For example, the second LED structural layer 92b (the maximum-via-area-ratio element) has a highest via area ratio of about 4.3%. The first LED structural layer 92a, the third LED structural layer 92c, and the fourth LED structural layer 92d each have a via area ratio of about 3.0%. The fifth LED structural layer 92e has a via area ratio of about 2.0%. The sixth LED structural layer 92f has a lowest via area ratio of about 1.2%.

In the LED array 102, the second LED structural layer 92b having the highest brightness has the highest via area ratio. The via area ratios of other LED structural layers tend to decrease monotonically with increasing distance from the second LED structural layer 92b. Specifically, the via area ratios of the LED structural layers other than the second LED structural layer 92b tend to decrease monotonically from the second LED structural layer 92b serving as a center toward the outside (both end sides). Uneven color can be suppressed (chromaticity distribution can be flattened and made uniform) by relatively increasing the via area ratio of an LED structural layer having a high brightness and relatively decreasing the via area ratio of an LED structural layer having a low brightness.

Note that as in the third LED structural layer 92c and the fourth LED structural layer 92d, there may be LED structural layers that are adjacent to each other and that have the same via area ratio. It is sufficient that a decreasing tendency is shown on the whole due to a change at at least one position. Also in the case where the size of vias is changed, the via area ratios of LED structural layers tend to decrease monotonically from an LED structural layer having the largest via size and serving as a center toward the outside (both end sides). Also in such a case, it is sufficient that a decreasing tendency is shown on the whole due to a change at at least one position even if LED structural layers having the same via size are partly arranged.

As described above, in an optical semiconductor laminate, regions where vias are formed become non-light-emitting regions. Therefore, a change in the via area ratio in the LED structural layers may cause a change in the brightness distribution characteristic of the resulting LED array. However, it is believed that the brightness distribution characteristic of the LED array is hardly changed as long as the change in the via area ratio in the LED structural layers is in the range of 10% or less and about several percent.

Fig. 2C is a plan view illustrating a modification of the second LED array. The via area ratio in each LED structural layer may be adjusted by changing the number of vias 20d per unit area (the density of vias 20d) as illustrated in Fig. 2B or changing the size (diameter) of each via 20d as illustrated in Fig. 2C.

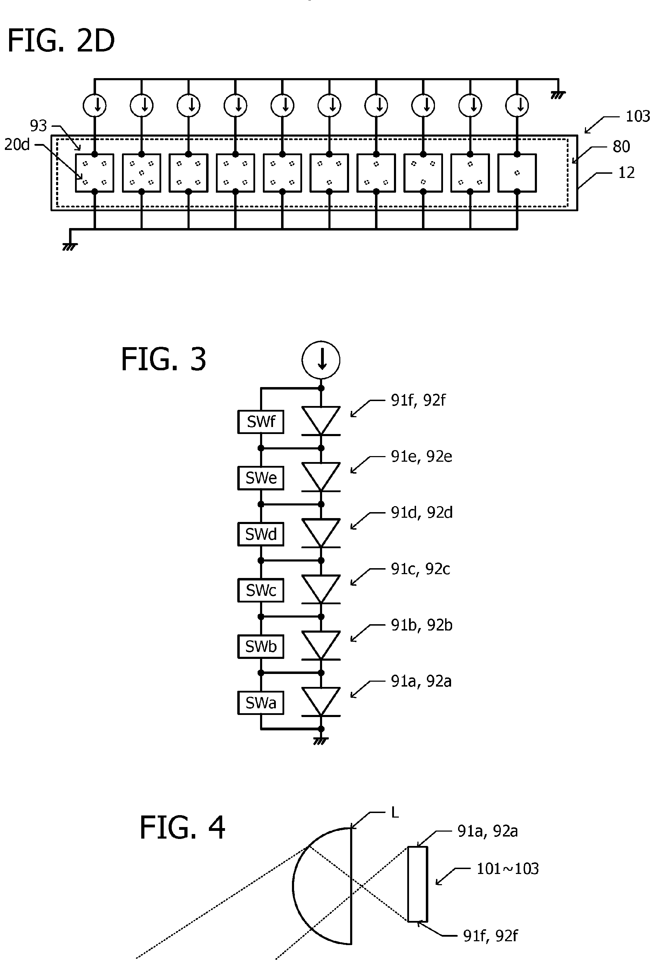

Fig. 2D is a plan view illustrating an overall structure of a third LED array 103 (second embodiment). The LED array 103 includes a plurality of LED structural layers 93 having the same planar shape. The planar shape of each of the LED structural layers 93 is, for example, a square shape.

The plurality of LED structural layers 93 are each connected to a power supply device so that an electric power can be independently supplied to the LED structural layers 93. The electric power is supplied to each of the LED structural layers 93 so that the brightness distribution characteristic of the whole LED array 103 becomes the characteristic shown in the graph in the lower part of Fig. 2A. Each of the LED structural layers 93 may be driven by a direct-current driving system or an alternating-current (duty) driving system.

Also in the LED array 103, the LED structural layer having the highest brightness has the highest via area ratio. The via area ratios of the other LED structural layers tend to decrease monotonically with increasing distance from the LED structural layer having the highest brightness. In this embodiment, the LED structural layer second from the left is assumed to have the highest brightness. Also in the case where a desired brightness distribution characteristic is obtained by adjusting the electric power supplied to the LED structural layers, uneven color can be suppressed by relatively increasing the via area ratio of an LED structural layer having a high optical output and relatively decreasing the via area ratio of an LED structural layer having a low optical output.

Fig. 3 is a schematic diagram illustrating a driving example of an LED array. Also for the LED arrays formed so that the LED structural layers have difference sizes as illustrated in Figs. 2A to 2C, the LED structural layers may each be independently driven. To independently drive the respective LED structural layers, a power supply may be provided for each of the LED structural layers. Alternatively, as illustrated in Fig. 3, switching elements SW may be provided so as to be able to select an LED structural layer to which a current is supplied.

In the case where the LED structural layers can be independently driven, the brightness distribution of the LED structural layers can be changed as required in accordance with the control of the power supply device. However, in lighting devices for vehicles, a basic orientation pattern is determined in advance, and an LED array is also formed in accordance with the orientation pattern. Accordingly, an LED array is optimally designed so that the via area ratio becomes maximum in an LED structural layer that has the highest brightness when such a basic orientation pattern is reproduced. As a result, an LED array is produced in which the via area ratio decreases with increasing distance from an LED structural layer having the highest via area ratio. In the case where the LED structural layers have different sizes as illustrated in Figs. 2A to 2C, an LED structural layer having the smallest size is the most easily provided with a high brightness and thus is preferably used as an element having the highest via area ratio.

Fig. 4 is a schematic view illustrating a lighting device for vehicles, the lighting device including an LED array. Light emitted from an LED array 101 or the like is radiated toward the ground through a lens L. The position of the LED array on the lighting device is not determined. However, when the light is radiated toward the ground, LED structural layers 91a and 92a and the leftmost LED structural layer in Fig. 2D illuminate the position closest to the lighting device, and LED structural layers 91f and 92f and the rightmost LED structural layer in Fig. 2D illuminate the position farthest from the lighting device.

As illustrated in the graph in the lower part of Fig. 2A, the peak of the brightness is located at a position shifted from the center toward an end in the direction in which LED structural layers are arranged. In addition, the LED structural layer having the highest via area ratio is disposed at a position shifted toward the end of the arrangement. Accordingly, the lighting device illustrated in Fig. 4 is disposed so that the end in the direction in which the maximum brightness peak is shifted (i.e., the side on which the LED structural layer having the highest via area ratio is disposed) illuminates a position close to the ground, and the opposite side illuminates a position far from the ground.

A description has been made of a case where a plurality of LED structural layers are formed on a support substrate. However, the structure is not limited as long as a plurality of light-emitting elements having a via-electrode structure are provided. For example, flip-chip-type elements may be arranged on a substrate.

The present invention has been described with reference to embodiments. However, the present invention is not limited to these embodiments. For example, in the embodiments, a description has been made of an example in which LED structural layers are arranged in one row on a support substrate. Alternatively, LED structural layers may be arranged in two or more rows. It is apparent for those skilled in the art that various modifications, improvements, and combinations can be made.

All examples and conditional language recited herein are intended for pedagogical purposes to aid the reader in understanding the invention and the concepts contributed by the inventors to furthering the art, and are to be construed as being without limitation to such specifically recited examples and conditions, nor does the organization of such examples in the specification relate to a showing of the superiority and inferiority of the invention. Although the embodiments of the invention have been described in detail, it should be understood that the various changes, substitutions, and alterations could be made hereto without departing from the scope of the, which is solely defined by the appended claims.

## Claims

1. A light-emitting diode array (100) comprising a substrate (12) and a plurality of light-emitting diodes (90) arranged above the substrate in one direction,
wherein each of the light-emitting diodes includes:
an optical semiconductor laminate (20) in which a p-type semiconductor layer (24), an active layer (23) having a light-emitting property, and an n-type semiconductor layer (22) are sequentially laminated from the substrate side;
a via hole (20d) that penetrates the p-type semiconductor layer and the active layer from the substrate side;
an n-side electrode (50) that is in contact with the n-type semiconductor layer through the via hole; and
a p-side electrode (30) disposed on a surface of the p-type semiconductor layer so as to avoid the via hole,
**characterised in that**,
in case that a ratio of a total area of the via hole to an area of the optical semiconductor laminate is defined as a via area ratio, and that a light-emitting diode having the highest via area ratio among the light-emitting diodes is defined as a maximum-via-area-ratio diode, via area ratios of light-emitting diodes except for the maximum-via-area-ratio diode tend to decrease monotonically with increasing distance from the maximum-via-area-ratio diode.

2. The light-emitting diode array according to Claim 1, further comprising a conductive layer (70) that is disposed between the substrate and the light-emitting diodes and that is connected to the n-side electrode and the p-side electrode of each of the light-emitting diodes to electrically connect the light-emitting diodes in series, an wherein an area of the maximum-via-area-ratio diode is smallest among the light-emitting diodes, and areas of the light-emitting diodes except for the maximum-via-area-ratio diode tend to increase monotonically with increasing distance from the maximum-via-area-ratio diode.

3. The light-emitting diode array according to Claim 1, further comprising a power supply device that is connected to the n-side electrode and the p-side electrode of each of the light-emitting diodes and that is capable of independently driving each of the light-emitting diodes, wherein when the light-emitting diodes are driven by the power supply device, light-emitting brightness of the maximum-via-area-ratio diode is highest among the light-emitting diodes, and light-emitting brightnesses of the light-emitting diodes except for the maximum-via-area-ratio diode tend to decrease monotonically with increasing distance from the maximum-via-area-ratio diode.

4. The light-emitting diode array according to Claim 1, further comprising a wavelength conversion layer (80) that is disposed so as to cover the light-emitting diodes and that converts a wavelength of light emitted from each of the light-emitting diodes.

5. The light-emitting diode array according to Claim 4, wherein:
the optical semiconductor laminate contains a GaN-based semiconductor material, and
the wavelength conversion layer contains a yellow phosphor material.

6. The light-emitting diode array according to Claim 1, wherein the maximum-via-area-ratio diode is disposed between a light-emitting diode disposed on one end side and a light-emitting diode disposed on the other end side.

7. The light-emitting diode array according to Claim 1, wherein the via hole of the maximum-via-area-ratio diode has the largest size among the light-emitting diodes, and via holes of the light-emitting diodes except for the maximum-via-area-ratio diode have sizes tending to decrease monotonically with increasing distance from the maximum-via-area-ratio diode.

8. A lighting device for vehicles, the lighting device comprising a light-emitting diode array (101, 102, 103) according to Claim 1, and an optical lens (L) disposed on an optical axis of the light-emitting diode array, wherein the maximum-via-area-ratio diode is disposed at a position shifted toward an end in a direction in which the light-emitting diodes are arranged, diode the light-emitting diode array is disposed so that light emitted from one end side close to the maximum-via-area-ratio diode illuminates a closer position and light emitted from the other end side illuminates a farther position.

## Patentansprüche

1. Leuchtdiodenanordnung (100), die ein Substrat (12) und eine Vielzahl von Leuchtdioden (90) aufweist, die über dem Substrat in einer Richtung angeordnet sind, wobei jede der Leuchtdioden Folgendes aufweist:
ein optisches Halbleiterlaminat (20), in dem eine Halbleiterschicht (24) des p-Typs, eine aktive Schicht (23) mit einer Lichtemissionseigenschaft, und eine Halbleiterschicht (22) des n-Typs sequentiell von der Substratseite aus laminiert sind;
ein Durchkontaktierungsloch (20d), das die Halbleiterschicht des p-Typs und die aktive Schicht von der Substratseite aus durchdringt;
eine Elektrode (50) der n-Seite, die sich in Kontakt mit der Halbleiterschicht des n-Typs befindet, und zwar durch das Durchkontaktierungsloch; und
eine Elektrode (30) der p-Seite, die auf einer Oberfläche der Halbleiterschicht des p-Typs so angeordnet ist, dass sie das Durchkontaktierungsloch umgeht,
**dadurch gekennzeichnet, dass**
in dem Fall, dass ein Verhältnis eines Gesamtbereichs des Durchkontaktierungslochs zu einem Bereich des optischen Halbleiterlaminats als ein Durchkontaktierungsbereichsverhältnis definiert ist, und dass eine Leuchtdiode mit dem höchsten Durchkontaktierungsbereichsverhältnis innerhalb der Leuchtdioden als Diode mit maximalem Durchkontaktierungsbereichsverhältnis definiert ist,
wobei die Durchkontaktierungsbereichsverhältnisse der Leuchtdioden mit Ausnahme der Diode mit maximalem Durchkontaktierungsbereichsverhältnis dazu neigen, monoton mit ansteigender Entfernung zu der Diode mit maximalem Durchkontaktierungsbereichsverhältnis abzunehmen.

2. Leuchtdiodenanordnung gemäß Anspruch 1, die ferner eine leitende Schicht (70) aufweist, die zwischen dem Substrat und den Leuchtdioden angeordnet ist und die mit der Elektrode der n-Seite und der Elektrode der p-Seite jeder Leuchtdiode verbunden ist, um die Leuchtdioden in Reihe elektrisch zu verbinden,
wobei ein Bereich der Diode mit maximalem Durchkontaktierungsbereichsverhältnis am kleinsten innerhalb der Leuchtdioden ist, und Bereiche der Leuchtdioden mit Ausnahme der Diode mit maximalem Durchkontaktierungsbereichsverhältnis dazu neigen, mit zunehmender Entfernung zu der Diode mit maximalem Durchkontaktierungsbereichsverhältnis monoton anzusteigen.

3. Leuchtdiodenanordnung gemäß Anspruch 1, die ferner eine Stromversorgungseinrichtung aufweist, die mit der Elektrode der n-Seite und der Elektrode der p-Seite jeder der Leuchtdioden verbunden ist, und die imstande ist, in unabhängiger Weise jede der Leuchtdioden anzutreiben,
wobei wenn die Leuchtdioden durch die Stromversorgungseinrichtung angetrieben werden, die Leuchthelligkeit der Diode mit maximalem Durchkontaktierungsbereichsverhältnis unter den Leuchtdioden am höchsten ist, und die Leuchthelligkeiten der Leuchtdioden mit Ausnahme der Diode mit maximalem Durchkontaktierungsbereichsverhältnis dazu neigen, mit zunehmender Entfernung zu der Diode mit maximalem Durchkontaktierungsbereichsverhältnis monoton abzunehmen.

4. Leuchtdiodenanordnung gemäß Anspruch 1, die ferner eine Wellenlängenumwandlungsschicht (80) aufweist, die so angeordnet ist, dass sie die Leuchtdioden abdeckt und die eine Wellenlänge des Lichts umwandelt, das von jeder der Leuchtdioden emittiert wird.

5. Leuchtdiodenanordnung gemäß Anspruch 4, wobei:
das optische Halbleiterlaminat ein GaN-basiertes Halbleitermaterial enthält, und
die Wellenlängenumwandlungsschicht ein gelbes Phosphormaterial enthält.

6. Leuchtdiodenanordnung gemäß Anspruch 1, wobei die Diode mit maximalem Durchkontaktierungsbereichsverhältnis zwischen einer Leuchtdiode angeordnet ist, die an einer Endseite angeordnet ist, und einer Leuchtdiode, die an der anderen Endseite angeordnet ist.

7. Leuchtdiodenanordnung gemäß Anspruch 1, wobei das Durchkontaktierungsloch der Diode mit maximalem Durchkontaktierungsbereichsverhältnis die größte Abmessung innerhalb der Leuchtdioden aufweist, und Durchkontaktierungslöcher der Leuchtdioden mit Ausnahme der Diode mit maximalem Durchkontaktierungsbereichsverhältnis Größen bzw. Abmessungen aufweisen, die dazu neigen, mit zunehmender Entfernung zu der Diode mit maximalem Durchkontaktierungsbereichsverhältnis monoton abzunehmen.

8. Leuchtvorrichtung für Fahrzeuge, wobei die Leuchtvorrichtung eine Leuchtdiodenanordnung (101, 102, 103) gemäß Anspruch 1 und eine optische Linse (L) aufweist, die auf einer optischen Achse der Leuchtdiodenanordnung angeordnet ist, wobei die Diode mit maximalem Durchkontaktierungsbereichsverhältnis bei einer Position angeordnet ist, die zu einem Ende in einer Richtung versetzt ist, in der die Leuchtdioden angeordnet sind, wobei die Diode und die Leuchtdiodenanordnung so angeordnet sind, dass Licht, das von einer Endseite dicht an der Diode mit maximalem Durchkontaktierungsbereichsverhältnis emittiert wird, eine nähere Position beleuchtet, und Licht, das von der anderen Endseite emittiert wird, eine entferntere Position beleuchtet.

## Revendications

1. Réseau de diodes électroluminescentes (100) comprenant un substrat (12) et une pluralité de diodes électroluminescentes (90) agencées au-dessus du substrat dans une même direction,
dans lequel chacune des diodes électroluminescentes comprend :
un stratifié semi-conducteur optique (20) dans lequel une couche semiconductrice de type P (24), une couche active (23) ayant des propriétés électroluminescentes, et une couche semiconductrice de type N (22) sont stratifiée successivement à partir du côté du substrat ;
un trou de via (20d) qui pénètre la couche semiconductrice de type P et la couche active à partir du côté du substrat ;
une électrode du côté N (50) qui est en contact avec la couche semiconductrice de type N par l'intermédiaire du trou de via ; et
une électrode du côté P (30) disposée sur une surface de la couche semiconductrice de type P de façon à éviter le trou de via,
**caractérisé en ce que**,
dans le cas où le rapport entre une surface totale du trou de via et une surface du stratifié semi-conducteur optique est défini comme étant un rapport de surface de via, et où une diode électroluminescente ayant le rapport de surface de via le plus élevé parmi les diodes électroluminescentes est définie comme étant une diode à rapport de surface de via maximum, les rapports de surface de via des diodes électroluminescentes excepté la diode à rapport de surface de via maximum tendent à décroître de manière monotone avec l'augmentation de la distance par rapport à la diode au rapport de surface de via maximum.

2. Réseau de diodes électroluminescentes selon la revendication 1, comprenant en outre une couche conductrice (70) qui est disposée entre le substrat et les diodes électroluminescentes et qui est connectée à l'électrode du côté N et à l'électrode du côté P de chacune des diodes électroluminescentes pour connecter électriquement les diodes électroluminescentes en série,
dans lequel la surface de la diode à rapport de surface de via maximum est la plus faible parmi les diodes électroluminescentes, et les surfaces des diodes électroluminescentes excepté la diode à rapport de surface de via maximum tendent à augmenter de manière monotone avec l'augmentation de la distance par rapport à la diode à rapport de surface de via maximum.

3. Réseau de diodes électroluminescentes selon la revendication 1, comprenant en outre un dispositif d'alimentation qui est connecté à l'électrode du côté N et à l'électrode du côté P pour chacune des diodes électroluminescentes et qui est capable de piloter indépendamment chacune des diodes électroluminescentes,
dans lequel lorsque les diodes électroluminescentes sont pilotées par le dispositif d'alimentation, la luminosité de l'émission de lumière de la diode à rapport de surface de via maximum est la plus élevée parmi les diodes électroluminescentes, et les luminosités d'émission de lumière des diodes électroluminescentes excepté la diode à rapport de surface de via maximum tendent à décroître de manière monotone avec l'augmentation de la distance par rapport à la diode à rapport de surface de via maximum.

4. Réseau de diodes électroluminescentes selon la revendication 1, comprenant en outre une couche de conversion de longueur d'onde (80) qui est disposée de manière à recouvrir les diodes électroluminescentes et qui convertit une longueur d'onde de la lumière émise par chacune des diodes électroluminescentes.

5. Réseau de diodes électroluminescentes selon la revendication 4, dans lequel :
le stratifié semi-conducteur optique contient un matériau semi-conducteur à base de GaN, et
la couche de conversion de longueur d'onde contient un matériau phosphorescent jaune.

6. Réseau de diodes électroluminescentes selon la revendication 1, dans lequel la diode à rapport de surface de via maximum est disposée entre une diode électroluminescente disposée sur un premier côté d'extrémité et une diode électroluminescente disposée sur l'autre côté d'extrémité.

7. Réseau de diodes électroluminescentes selon la revendication 1, dans lequel le trou de via de la diode à rapport de surface de via maximum a la taille la plus grande parmi les diodes électroluminescentes, et les trous de via des diodes électroluminescentes excepté la diode à rapport de surface de via maximum ont des tailles tendant à décroître de manière monotone avec l'augmentation de la distance par rapport à la diode à rapport de surface de via maximum.

8. Dispositif d'éclairage pour des véhicules, le dispositif d'éclairage comprenant un réseau de diodes électroluminescentes (101, 102, 103) selon la revendication 1, et une lentille optique (L) disposée sur un axe optique du réseau de diodes électroluminescentes,
dans lequel la diode à rapport de surface de via maximum est disposée à une position décalée en direction d'une extrémité dans une direction dans laquelle les diodes électroluminescentes sont agencées, et le réseau de diodes électroluminescentes est disposé de telle sorte que de la lumière émise à partir d'une première extrémité proche de la diode à rapport de surface de via maximum éclaire une position plus proche et la lumière émise à partir de l'autre côté d'extrémité éclaire une position plus éloignée.
